# EUROPEAN PATENT APPLICATION

(11) **EP 4 651 373 A1**
(43) Date of publication of application: **19.11.2025**
(21) Application number: 25174589.9
(22) Date of filing: 06.05.2025
(51) Int. Cl.: H03F 1/02, H03F 3/195, H03F 3/21, H03F 3/24, H03F 3/72

(54) **RECONFIGURABLE AMPLIFIER SYSTEM WITH A SWITCHABLE MULTIPLE-COIL TRANSFORMER**

(30) Priority: 13.05.2024 US 202418662466
(71) Applicant: NXP USA, Inc., Austin, TX 78735 (US)
(72) Inventor: CHEN, Runzhou, 5656AG Eindhoven (NL); TAM, Sai-Wang, 5656AG Eindhoven (NL); XIE, Juan, 5656AG Eindhoven (NL); XIAO, Xiao, 5656AG Eindhoven (NL); NISSIM, Brian Jacob, 5656AG Eindhoven (NL); WONG, Alden, 5656AG Eindhoven (NL); CARNU, Ovidiu, 5656AG Eindhoven (NL)
(74) Representative: Hardingham, Christopher Mark

(57) **Abstract**

Embodiments of a method and apparatus for reconfiguring an amplifier system with a switchable multiple-coil transformer are disclosed. In an example, a transformer with multiple switches is described. The transformer includes a first coil electrically coupled to a pre-power amplifier that is configured to receive an input signal, a second coil inductively coupled to the first coil and configured to be electrically coupled to a first power amplifier, a third coil inductively coupled to the first coil and electrically coupled to a second power amplifier, and a switch to alternately connect and disconnect the third coil from a ground.

## Description

### BACKGROUND

Electronics devices frequently use power amplifiers embedded in an integrated circuit (IC). The power amplifier may be for radio transmission, e.g., Wi-Fi, or cellular networks, or for audio speakers, or video displays. An embedded power amplifier may be produced at high volume and low cost after it has been designed and laid out in a particular semiconductor library for a particular manufacturing process. Older, predictable, and reliable technologies (sometimes referred to as nodes or feature sizes) may be used for power amplifiers further reducing the cost.

### SUMMARY

Embodiments of a method and apparatus for reconfiguring an amplifier system with a switchable multiple-coil transformer are disclosed. In an example, a transformer is described. The transformer includes a first coil electrically coupled to a pre-power amplifier that is configured to receive an input signal, a second coil inductively coupled to the first coil and configured to be electrically coupled to a first power amplifier, a third coil inductively coupled to the first coil and electrically coupled to a second power amplifier, and a first switch to alternately connect and disconnect the third coil from a ground.

In some embodiments, the first switch alternately connects and disconnects the third coil on one side of an output of the third coil, the transformer further including a first pair of switches including the switch and a second switch of the first pair of switches to alternately connect and disconnect the third coil from the ground with the first switch at another side of the output of the third coil.

Some embodiments include a third switch to alternately open and close a break in the third coil.

Some embodiments include a second pair of switches including the third switch and a fourth switch of the second pair of switches to alternately open and close a break in the third coil with the third switch at another side of the third coil.

In some embodiments, the first pair of switches is configured to connect the third coil to the first power amplifier and the second pair of switches is configured to close the break in the third coil when the first power amplifier is active and wherein the first pair of switches is configured to ground the third coil and the second pair of switches is configured to open the break in the third coil when the second power amplifier is active

In some embodiments, the second power amplifier is external to the transformer, the transformer further including an output pad coupled to the third coil and configured to connect to the second power amplifier.

Some embodiments include a center tap of the third coil coupled to a bias gate of the second power amplifier to provide a bias voltage to the second power amplifier when the switch disconnects the third coil from ground.

Some embodiments include a bias switch to couple a first bias from the center tap to the bias gate when the bias switch connects the third coil to ground and a second bias when the bias switch disconnects the third coil from the ground.

In some embodiments, the bias switch provides the first bias when the second power amplifier is deactivated and the second bias when the second power amplifier is activated.

In an example, a method includes receiving an input signal at an input port of a pre-power amplifier, receiving a pre-power amplifier signal at a first coil of a transformer that is electrically coupled to the pre-power amplifier, inductively coupling the pre-power amplifier signal through the first coil to a second coil which is electrically coupled to a first power amplifier, inductively coupling the pre-power amplifier signal through the first coil to a third coil which is electrically coupled to a second power amplifier, and alternately connecting and disconnecting the third coil from a ground.

Some embodiments include alternately opening and closing a break in the third coil with the alternately connecting and disconnecting the third coil from the ground to alternately connect and disconnect the second power amplifier.

Some embodiments include activating a first and a second cell of the pre-power amplifier to supply the first power amplifier when a switch connects the third coil to the ground.

Some embodiments include coupling a first bias from a center tap of the third coil to a bias gate of the first power amplifier when the switch connects the third coil to the ground and coupling a second bias to the bias gate when the switch disconnects the third coil from the ground.

In an example, a reconfigurable amplifier system includes a pre-power amplifier having an input port configured to receive an input signal, an internal power amplifier, a transformer having a first coil electrically coupled to the pre-power amplifier, a second coil inductively coupled to the first coil and configured to be electrically coupled to an external power amplifier, and a third coil inductively coupled to the first coil and electrically coupled to the internal power amplifier, and a switch to alternately connect and disconnect the third coil from a ground to connect and disconnect the internal power amplifier.

In some embodiments, the pre-power amplifier comprises a first cell and a second cell and wherein the first and second cell are active to supply the external power amplifier when the switch connects the third coil to the ground.

In some embodiments, the pre-power amplifier is configured to supply the internal power amplifier when the switch disconnects the third coil from the ground when the second cell is not active.

In some embodiments, the first cell comprises a first cascode amplifier and the second cell comprises a second cascode amplifier and wherein the first cascode amplifier and the second cascode amplifier are connected in parallel to the input port and to the first coil.

Some embodiments include a third switch to alternately open and close a break in the third coil such that the break is opened when the third coil is connected to the ground.

In some embodiments, the third switch is an embedded field effect transistor.

Some embodiments include a semiconductor substrate and wherein the pre-power amplifier, the transformer, the internal power amplifier and the switch are formed on the semiconductor substrate and the external power amplifier is not formed on the semiconductor substrate.

Other aspects in accordance with the invention will become apparent from the following detailed description, taken in conjunction with the accompanying drawings, illustrated by way of example of the principles of the invention.

### BRIEF DESCRIPTION OF THE DRAWINGS

Fig. 1 is a diagram of an integrated circuit amplifier system with reconfigurable power amplifier connections in accordance with an embodiment of the invention.
Fig. 2 is a diagram of a portion of a reconfigurable amplifier system in an external power amplifier mode in accordance with an embodiment of the invention.
Fig. 3 is a diagram of a portion of a reconfigurable amplifier system that is reconfigured in an intemal PA mode in accordance with an embodiment of the invention.
Fig. 4 is a diagram of a pre-power amplifier and an internal power amplifier connected through a three-coil transformer in accordance with an embodiment of the invention.
Fig. 5 is a process flow diagram of operating a reconfigurable amplifier system in accordance with an embodiment of the invention.

Throughout the description, similar reference numbers may be used to identify similar elements.

### DETAILED DESCRIPTION

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The present invention may be embodied in other specific forms without departing from its spirit or essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

Different IC amplifier applications require different output power levels, different output impedance levels, different amounts of linearity or efficiency at different power output levels, and other characteristics. If a single IC chip can meet the needs of different applications, then it can be made at higher volume reducing fabrication cost and engineering time.

For wireless communications, an amplifier system may be required to handle high data rates with stringent linearity requirements and low error vector magnitude over a wide frequency range. A reconfigurable amplifier system with different power amplifiers for different frequencies and different data rates may support these requirements. Such an IC amplifier system may be configured for a particular use, or it may be reconfigurable in use for different modes. As an example, a Wi-Fi transmitter may operate in a lower power lower frequency mode at some times and a higher power, higher frequency mode at other times. Using two different power amplifiers and a set of switches, an IC amplifier may be reconfigured to serve both modes at different times. Such an IC amplifier system may be configured for many different wireless connectivity solutions.

An IC amplifier system may have signal inputs, e.g., pins or bumps, coupled to a pre-power amplifier (PPA) or preamplifier, coupled to an input transformer, coupled to a power amplifier (PA), coupled to an output transformer, coupled to signal outputs, e.g., pins or bumps. A power supply is coupled in parallel to provide the different levels of power to drive the PPA and the PA. The signal inputs are coupled to signal processing circuitry and the signal outputs are coupled to antennas, transducers, or other components. In another application the signal inputs are coupled to antennas, transducers, or other components and the output pins are coupled to signal processing circuitry. The signal processing circuitry may be on the same or a different IC.

As presented herein, a single IC, e.g. a single chip, is reconfigurable to use either an internal PA or, for higher power, an external PA. An external PA allows for higher power, higher efficiency, and better cooling of the PA while the rest of the components are on the low-power, inexpensive IC. Multiple external PAs may be coupled to a single IC. The reconfigurable IC allows a simple chip and chip design to be used in a wide range of different applications.

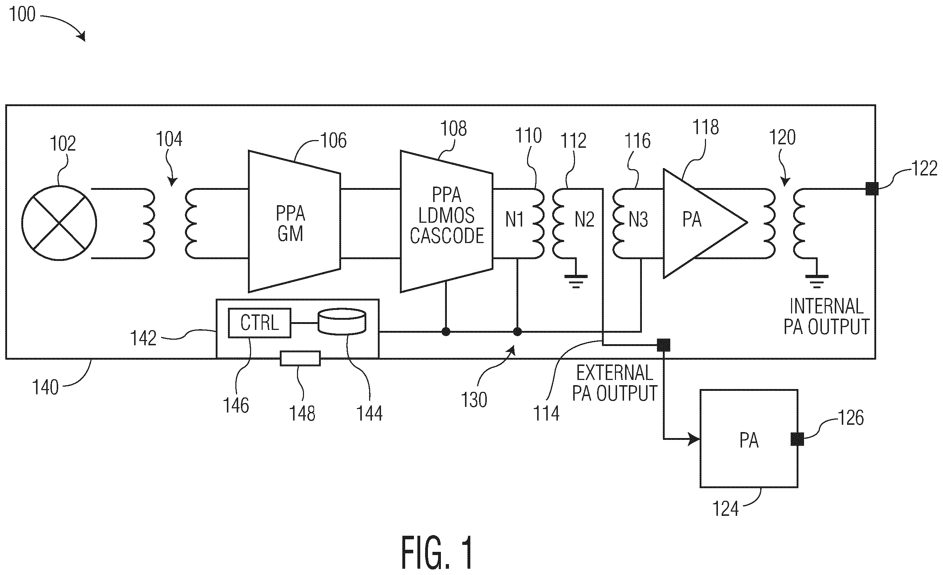

Fig. 1 is a diagram of an IC amplifier system 100 with reconfigurable PA connections. A source 102 provides an analog signal for amplification. The source 102 may be inputs, e.g., pins or bumps, a digital signal processor (DSP), receiver or any other suitable source of an analog signal for amplification. The analog signal may be in the form of symbols, points, tones, waveforms, or another type of signal for radio frequency transmission through an antenna.

The source 102 is coupled through a first coil 104 to a current conversion PPA, e.g., an operational transconductance amplifier (OTA) with a suitable transconductance (Gm), which is coupled to the gain stage PPA 108 which may include laterally-diffused metal-oxide semiconductor (LDMOS) amplifiers, cascode amplifiers, and other circuitry to provide gain and impedance control to a PA. The gain stage PPA 108 may include a 2-stack cascode amplifier to provide a voltage gain between the source 102 and a PA. The gain stage PPA 108 is coupled to a first coil 110 of N1 turns of a transformer 130 with a triple core. The first coil is the input coil electrically connected to the gain stage PPA 108. A second coil 112 of the transformer 130 with N2 turns is inductively coupled to the first coil 110 and electrically coupled to an external PA output 114. The external PA output 114 may be coupled, in some applications, to an external PA 124 which may have an output 126 to connect to an antenna, transducer, or other device. A third coil 116 with N3 turns is electrically coupled to an internal PA 118 and also inductively coupled to the first coil 110.

The output of the internal PA 118 is coupled through a transformer 120 to an internal PA output 122. The signal at the external PA output is configured to drive an external PA (not shown) with a suitable gain and impedance. The external PA may be configured for any of a variety of different uses. The internal PA 118 amplifies the current signal from the gain stage PPA 108 to generate the internal PA output 122 as a high-power output signal or may be disconnected for power savings when not in use, e.g., when an external PA is connected. Either PA may be coupled to an antenna, transducer, DSP, or any other suitable device. Using switches, as described below, the three-coil transformer may be configured to connect to either an internal PA or an external PA or it may be reconfigured during use as amplification demands change.

The current conversion PPA 106, gain stage PPA 108 transformer 130, and internal PA 118 may all be fabricated as a single chip shown as IC chip 140, e.g. on the same semiconductor substrate. The IC chip may include an input port to connect to the single source, e.g., source 102, an internal PA output 122 and an external PA output PA. The external PA 124 is not formed on the semiconductor substrate of this IC chip 140 but on a different substrate as a separate component. This allows for better cooling and higher power than if the PA were internal to the IC chip 140. Additional components are not shown in these and the other drawings in order to simplify the diagram such as power supplies, controllers, regulators, input switching, etc.

The IC chip 140 includes a processor 142 to control the amplifier system 100. The processor has a memory or storage 144, e.g., a machine-readable medium, with instructions and parameters that are used by a controller 146 to determine the configuration of the amplifier system 100. The processor 142 is coupled to the gain stage PA 108, to the first coil 110 and the third coil 116 to operate switches at those devices and control the configuration as described in more detail below. The processor 142 may be coupled to other parts of the amplifier system and to other components (not shown) to control their operation. In examples, there are multiple instances of the amplifier system on the IC chip 140 all coupled to the same processor 142. The processor 142 may include an external data port 148 to send and receive configuration parameters, commands, and control from higher layer components of a system. The processor 142 may be in the form of a central processing unit, a controller, a state machine, a set of logic gates, an application specific integrated circuit, or another device. The processor 142 may be integrated on to the same chip, e.g., IC chip 140, as shown, or it may be external to the IC amplifier system and formed on a different semiconductor substrate.

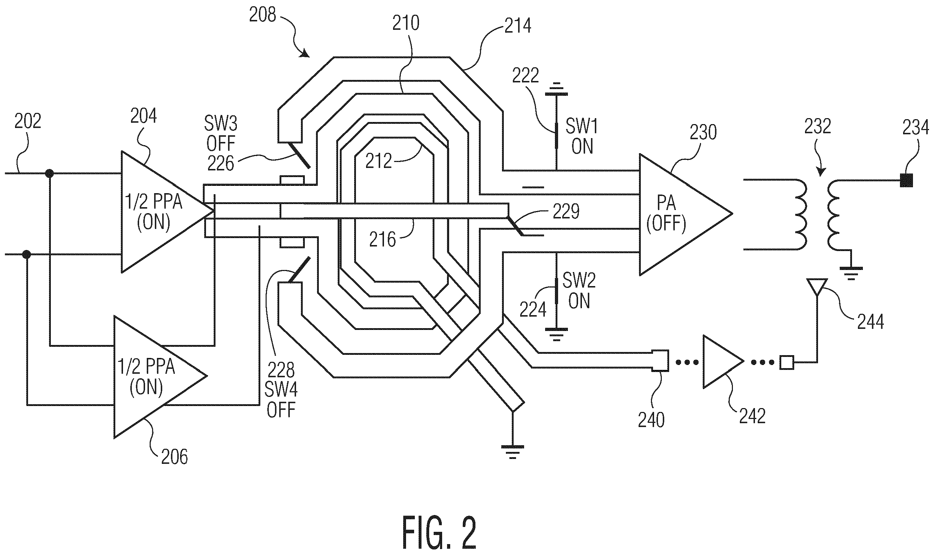

Fig. 2 is a diagram of a portion of a reconfigurable amplifier system in an external power amplifier mode. The input signals are received at an input port 202 which may be windings as shown in Fig. 1 or another input including pins or bumps on an IC chip. The input is coupled to a PPA which in this example has been divided into two parts a first PPA cell 204 of the PPA and a second PPA cell 206 of the PPA. The current PPA portion of the PPA may be shared or duplicated by the two PPA cells. For this configuration, the first PPA cell 204 is switched on and the second PPA cell 206 is switched off to save power. The PPA described above may contain pairs of switches to switch portions of the PPA on and off. In one example, the PPA includes a two-stack cascode amplifier with two PPA cells, so that the first PPA cell 204 has one of the two-stack cascodes and the second PPA cell 206 has another of the two-stack cascodes. One of the PPA cells is turned off to reduce the gain of the preamplifier for use with the internal power amplifier.

A transformer 208 has three coils. A first coil 210 is on the input side and coupled to the first PPA cell 204 of the PPA. The first coil is inductively coupled to a second coil 212 and inductively coupled to a third coil 214. The first coil 210 conducts the PPA output to the second coil 212 which, in this example, is coupled to an external power amplifier 242 through an external PA pad 240. The third coil 214 is electrically coupled to an internal power amplifier 230 which is coupled to an output pad 234. The transformer 208 has two pairs of embedded switches, e.g., metal oxide semiconductor (MOS) switches, so that when the internal PA 230 is not connected the signal path to the internal PA will be cut off and the gates of the internal PA 230 are grounded.

The amplifier system also has an output transformer 232 coupled to the internal PA 230 on one side and to an output pad 234 of the amplifier system. In this configuration, the output pad 234 is shown as not being connected. However, the internal PA 230 may be connected to an antenna so that it is ready to transmit if it is switched back on.

The first pair of switches is for the third coil 214 output to the internal PA 230. The first pair of switches has a first switch 222 in an ON state to ground one side of the third coil 214 and a second switch 224 in the ON state to ground the other side of the third coil 214. In this way, the first pair of switches isolate the third coil 214 from the internal PA 230. The first switch 222 and the second switch 224 may be embedded with the transformer of the first coil 210, the second coil 212, or the third coil 214. The switches are embedded in that the switches are formed (e.g., fabricated) on the same substrate as the coils and part of the same integrated circuit chip.

During this external PA 242 mode, the fourth switch 228 is off. A large signal will swing across the fourth switch 228. In order to avoid a breakdown of the fourth switch 228, the drain of the fourth switch may be biased at VDD, e.g., 1.2V, while the source will be connected to ground as is the second switch 224. The second switch 224 may be shorted to ground to make sure that there is no breakdown at the fourth switch 228 and also to shut off the internal PA 230.

In an example, the first switch 222, the second switch 224, the third switch 226, the fourth switch 228, and the bias switch are all field effect transistors (FETs). In the external PA mode of Fig. 2, the third switch 226 and the fourth switch 228 may be set so that the source and gate voltage are at about 0V and the drain voltage is set to VDD. At the same time, the first switch 222 and the second switch 224 may be set so that the drain voltage and the source voltage are set to 0V. The gate voltage is set to some ON state, ideally VDD but more likely an intermediate level to reduce stress on the device. Like the first switch 222 and the second switch 224, the third switch 226 and the fourth switch 228 may also be embedded with the transformer in the sense that they are formed on the same substrate as the coils and part of the same integrated circuit chip.

The second pair of switches effectively break the third coil 214 so that it functions as a core and is not coupled to any other coil. The second pair of switches has a first switch 226 in an OFF state to open one side of the third coil 214 and a second switch 228 in the OFF state to open a second side of the third coil 214. During this external PA mode, a large swing appears at the third coil. The switches isolate the voltage on the care to avoid any breakdown.

With the first pair of switches ON and the second pair of switches OFF as shown, the first PPA cell 204 is disconnected from the third coil 214 and from the internal PA 230. There is a break in the third coil due to the positions of the second pair of switches.

The third coil 214 also has a center tap 216 that is coupled from the PPA 204 to a bias switch 229. The bias switch 229 is in a first position to provide a first bias as the gate voltage to the internal PA 230. The third coil center tap 216 is biased at a higher bias than in the second position in order to provide a large swing for the first pair of switches.

The bias switch 229 may be implemented as a MUX to control the bias of the internal PA 230. In this external PA mode, the internal PA 230 is in the off mode. The bias switch 229 switches the bias of the PA to 0V which is the off mode.

The amplifier system also has an output transformer 232 coupled to the internal PA 230 on one side and to an output pad 234 of the amplifier system. In examples, the output pad 234 is an output pad of an IC chip. The output pad may be coupled to any sink to suit the particular use of the amplifier, e.g., an antenna 236 for radio frequency transmission. The values of the gain, the bias, the output power, and other parameters of the amplifier may be adapted to suit different applications.

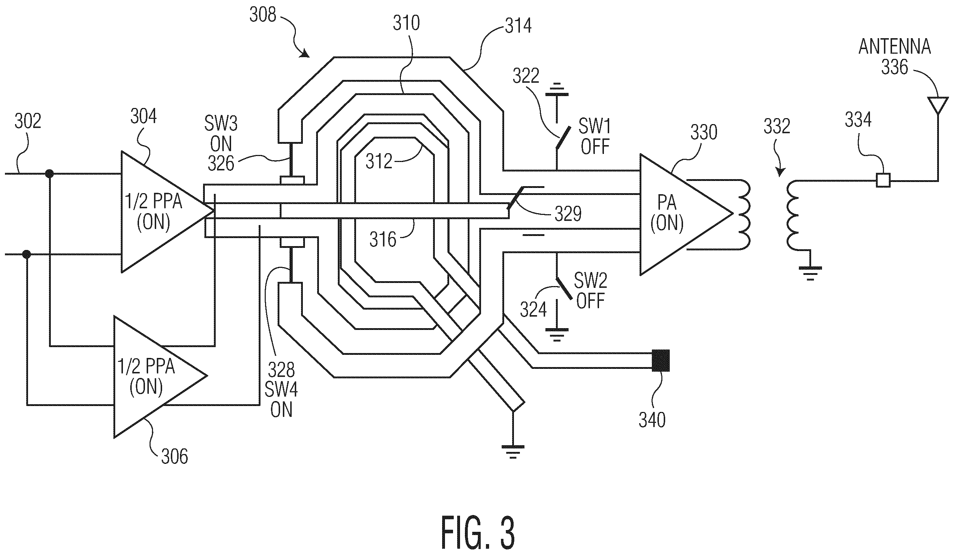

Fig. 3 is a diagram of a portion of a reconfigurable amplifier system that is reconfigured in an internal PA mode. The amplifier system may be configured to support the internal PA 330 or an external PA 342 by the operation of a few switches. This allows the PPA and the transformer 308 to provide a suitable gain for the selected PA configuration. The input signals are received at an input port 302 which may be windings as shown in Fig. 1 or another input including pins or bumps on an IC chip. The input is coupled to a PPA which in this example has been divided into two parts, a first PPA cell 304 of the PPA and a second PPA cell 306 of the PPA. For this configuration, both the first PPA cell 304 and the second PPA cell 306 are switched on and so the two parts operate in effect as one and provide the full gain capability of both parts.

A transformer 308 has three coils. A first coil 310 is on the input side and electrically coupled to the two PPA cells of the PPA. In this configuration, the first coil 310 inductively conducts the signal to a second coil 312 coupled to an external amplifier output pad 340. However, no external amplifier is connected or activated. A third coil 314 is inductively coupled to the first coil 310 and electrically coupled to an internal amplifier 330.

The same two pairs of switches as are shown in Fig. 2 are used in this example, but the switches are in the opposite configuration to connect the internal PA 330. As in the example of Fig. 2, these switches may also be embedded. The first pair of switches is for an output of the third coil 314 that is coupled to the internal PA 330. The first pair of switches has a first switch 322 to disconnect the grounding of one side of the output of the third coil 314 and a second switch 324 to disconnect the other side of the output of the third coil 314 from ground. The second pair of input switches connect paths of the third coil 314 to close the breaks. This allows the signal from the first PPA cell 304 coupled to the first coil 310 to be inductively coupled to the third coil 314 and to be conducted to the internal PA 330. The second pair of input switches has a first input switch 326 to close the break on one side of third coil 314 and a second input switch 328 to close the break on another side of the third coil 314. Both the first PPA cell 304 and the second PPA cell 306 are electrically connected to the first coil 310 but the second PPA cell 306 is off, so it does not affect the signal that is coupled to the internal PA 330. With the first pair of switches OFF and the second pair of switches ON as shown, the first PPA cell 304 is inductively coupled to third coil 314 which is coupled by its output to the internal PA 330 and not grounded.

The third coil 314, which is coupled to the first PPA cell 304 and the second PPA cell 306, also has a center tap 316 which is coupled from the first PPA cell 304 to a bias switch 329. The bias switch causes the center tap 316 to be biased to provide a gate voltage to the internal PA 330. The bias switch 329 at the opposite end of the center tap 316 couples a second bias to the internal PA 330. This activates the internal PA to the supplied power at the intended gain. The internal PA 330 is coupled to an output pad 334 through a transformer 332. The output pad 334 is shown as being coupled to an antenna, but any other suitable sink may be used.

The bias switch 329 operates as a MUX to control the bias of the internal PA 330. When the internal PA is ON, the bias switch 329 will bias the PA 230 to drive it to operate in class AB mode, e.g., about 0.5V. By comparison, in the example of Fig. 2, the PA 230 is in an OFF mode and the PA bias 229 switch biases the PA 230 at 0V. With a differential PA, the center tap 316 of the transformer provides a bias for the PA 330 in common mode.

The second coil 312 is coupled to an external amplifier output pad 340 for an external PA (not shown). In this configuration, no external PA is used even if one is attached to the amplifier system IC chip. The external PA and the internal PA 330 may be coupled to any sink to suit the particular use of the respective PA, e.g., an antenna 336 for radio frequency transmission. The antenna 336 for the internal PA may be the same or different from the antenna 244 of the external PA 242. The values of the gain, the bias, the output power, and other parameters of the amplifier may be adapted to suit different applications.

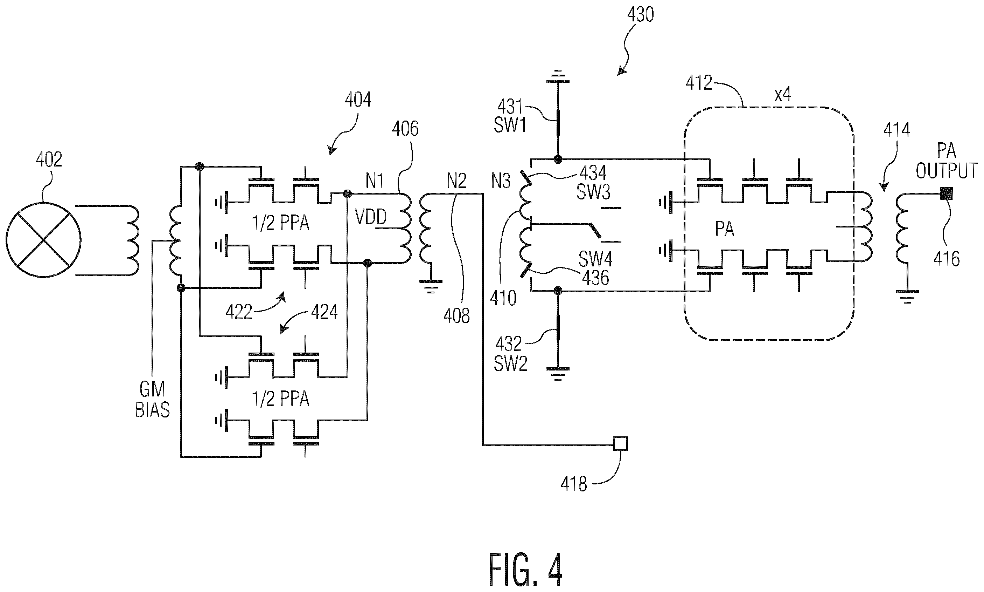

Fig. 4 is a diagram of a pre-power amplifier and an internal power amplifier connected through a three-coil transformer. Details of the amplifier circuitry are shown in more detail. An input signal 402 is received at a PPA 404 and the gain-controlled output signal from the PPA is electrically coupled to a first coil 406 which is inductively coupled to a second coil 408 and a third coil 410. The second coil has leads to electrically couple the second coil to a PA output pad 418.

The PPA 404 has a first cascode amplifier 422 in a first half of the PPA or the first PPA cell and a second cascode amplifier 424 in a second half of the PPA or the second PPA cell. The two cascode amplifiers are both two-stack cascodes although more stages may be used to suit different implementations. The two cascodes are connected in parallel at the top of each stack to the same input. The outputs of each stack are coupled in parallel to the first coil 406. As discussed above, a single cascode may be used to provide a first level of gain for the internal PA and both cascodes may be used to provide a higher level of gain for the external PA. There may be more cascode amplifier coupled in parallel to provide additional output power levels. While the two cascodes are shown as identical, they may be different in order to provide three levels of output with the first PPA cell, the second PPA cell, and both together.

Similarly, the internal PA 412 is coupled to the third coil 410 to amplify the input signal 402 for an output pad 416 that is coupled to the internal PA 412 through a transformer 414. The internal PA may also be configured as an array of cascode amplifiers, as shown, or in any other way. The internal PA is coupled to the third coil 410 through a switch array 430. These switches may be embedded into the third coil. The first switch 431 and the second switch 432 are shown as ON so that the third coil 410 is grounded on both sides. The third switch 434 and the fourth switch 436 are shown in an OFF position to open or break the third coil 410 by creating gaps in the third coil 410, effectively neutralizing it to the extent that the grounding from the first switch 431 and the second switch432 have not already neutralized the third coil 410.

In the present description electrically coupled is used to refer to a direct or indirect connection between two components that uses electrical conductors, e.g., traces, metal lines, wires, etc. Inductively coupled is used to refer to a connection made through an electromagnetic field interaction across a distance as between two coils that are adjacent but not in physical contact.

Using an on-chip three-coil transformer with embedded switches, a Wi-Fi amplifier system can be reconfigurable, and support two output modes: internal mode and external mode with different output power levels. The system can switch between these two modes by the embedded switches. This architecture enables the possibility of achieving reconfiguration with minimum device overhead, chip area and decent output power, error vector magnitude (EVM), and device lifetime.

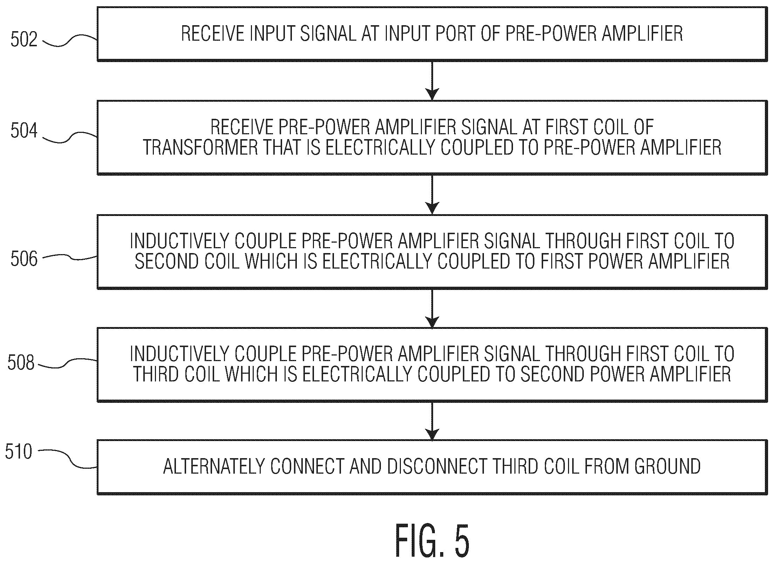

Fig. 5 is a process flow diagram of operating a reconfigurable amplifier system in accordance with an embodiment of the invention. At 502 an input signal is received at an input port of a pre-power amplifier. At 504 a pre-power amplifier signal is received at a first coil of a transformer that is electrically coupled to the pre-power amplifier. At 506 the pre-power amplifier signal is inductively coupled through the first coil to a second coil which is electrically coupled to a first power amplifier. At 508 the pre-power amplifier signal is inductively coupled through the first coil to a third coil which is electrically coupled to a second power amplifier. At 510 the third coil is alternately connected and disconnected from a ground.

The method of Fig. 5 reflects continuous operation of the amplifier system described above either upon initial configuration or over time in use. There may also be other switches and coils and amplifiers. The switches may be operated by an external controller that is connected to the switches to perform this operation and other tasks suitable for the system. The controller may have a processing core and memory, or it may operate using firmware or logic gates.

Although the operations of the method(s) herein are shown and described in a particular order, the order of the operations of each method may be altered so that certain operations may be performed in an inverse order or so that certain operations may be performed, at least in part, concurrently with other operations. In another embodiment, instructions or sub-operations of distinct operations may be implemented in an intermittent and/or alternating manner.

It should also be noted that at least some of the operations for the methods described herein may be implemented using software instructions stored on a computer useable storage medium for execution by a computer. As an example, an embodiment of a computer program product includes a computer useable storage medium to store a computer readable program.

The computer-useable or computer-readable storage medium can be an electronic, magnetic, optical, electromagnetic, infrared, or semiconductor system (or apparatus or device). Examples of non-transitory computer-useable and computer-readable storage media include a semiconductor or solid-state memory, magnetic tape, a removable computer diskette, a random-access memory (RAM), a read-only memory (ROM), a rigid magnetic disk, and an optical disk. Current examples of optical disks include a compact disk with read only memory (CD-ROM), a compact disk with read/write (CD-R/W), and a digital video disk (DVD).

Alternatively, embodiments of the invention may be implemented entirely in hardware or in an implementation containing both hardware and software elements. In embodiments which use software, the software may include but is not limited to firmware, resident software, microcode, etc.
Although specific embodiments of the invention have been described and illustrated, the invention is not to be limited to the specific forms or arrangements of parts so described and illustrated. The scope of the invention is to be defined by the claims appended hereto and their equivalents.

## Claims

1. A transformer comprising:
a first coil electrically coupled to a pre-power amplifier that is configured to receive an input signal;
a second coil inductively coupled to the first coil and configured to be electrically coupled to a first power amplifier;
a third coil inductively coupled to the first coil and electrically coupled to a second power amplifier; and
a first switch configured to alternately connect and disconnect the third coil from a ground.

2. The transformer of claim 1, wherein the first switch alternately connects and disconnects the third coil on one side of an output of the third coil, the transformer further comprising a first pair of switches including the first switch and a second switch of the first pair of switches to alternately connect and disconnect the third coil from the ground with the first switch at another side of the output of the third coil.

3. The transformer of claim 2, further comprising a third switch to alternately open and close a break in the third coil.

4. The transformer of claim 3, further comprising a second pair of switches including the third switch and a fourth switch of the second pair of switches to alternately open and close a break in the third coil with the third switch at another side of the third coil.

5. The transformer of claim 4, wherein the first pair of switches is configured to connect the third coil to the first power amplifier and the second pair of switches is configured to close the break in the third coil when the first power amplifier is active and wherein the first pair of switches is configured to ground the third coil and the second pair of switches is configured to open the break in the third coil when the second power amplifier is active.

6. The transformer of any preceding claim, wherein the second power amplifier is external to the transformer, the transformer further comprising an output pad coupled to the third coil and configured to connect to the second power amplifier.

7. The transformer of any preceding claim, further comprising a center tap of the third coil coupled to a bias gate of the second power amplifier to provide a bias voltage to the second power amplifier when the switch disconnects the third coil from ground.

8. The transformer of claim 7, further comprising a bias switch to couple a first bias from the center tap to the bias gate when the bias switch connects the third coil to ground and a second bias when the bias switch disconnects the third coil from the ground.

9. The transformer of claim 8, wherein the bias switch provides the first bias when the second power amplifier is deactivated and the second bias when the second power amplifier is activated.

10. A reconfigurable amplifier system comprising:
the transformer according to any preceding claim.
the pre-power amplifier having an input port configured to receive an input signal; and
the internal power amplifier.

11. A method comprising:
receiving an input signal at an input port of a pre-power amplifier;
receiving a pre-power amplifier signal at a first coil of a transformer that is electrically coupled to the pre-power amplifier;
inductively coupling the pre-power amplifier signal through the first coil to a second coil which is electrically coupled to a first power amplifier;
inductively coupling the pre-power amplifier signal through the first coil to a third coil which is electrically coupled to a second power amplifier; and
alternately connecting and disconnecting the third coil from a ground.

12. The method of claim 11, further comprising alternately opening and closing a break in the third coil with the alternately connecting and disconnecting the third coil from the ground to alternately connect and disconnect the second power amplifier.

13. The method of claim 11 or 12, further comprising activating a first and a second cell of the pre-power amplifier to supply the first power amplifier when a switch connects the third coil to the ground.

14. The method of claim 13, further comprising coupling a first bias from a center tap of the third coil to a bias gate of the first power amplifier when the switch connects the third coil to the ground and coupling a second bias to the bias gate when the switch disconnects the third coil from the ground.
